# FASCICULE DE BREVET EUROPEEN

(11) **EP 1 542 233 B1**
(45) Date de publication et mention de la délivrance du brevet: **30.05.2007**
(21) Numéro de dépôt: 04029016.5
(22) Date de dépôt: 08.12.2004
(51) Int. Cl.: G11C 8/04, G11C 8/12

(54) **Mémoire série comprenant des moyens de protection d'un plan mémoire étendu pendant une opération d'écriture**
Serieller Speicher mit Mitteln zum Schutz eines erweiterten Speicherfeldes während einer Schreiboperation
Serial memory comprising means for protecting an extended memory range during a write operation

(30) Priorité: 12.12.2003 FR 0314622; 12.12.2003 FR 0314621; 12.12.2003 FR 0314628
(43) Date de publication de la demande: 15.06.2005
(73) Titulaire: STMicroelectronics S.A., 92210 Montrouge (FR)
(72) Inventeur: Zink, Sébastien Résidence les Capucines, Bât. A, 13090 Aix en Provence (FR); Cavalieri, Paola, 13790 Rousset (FR); Leconte, Bruno, 13790 Rousset (FR)
(74) Mandataire: Marchand, André

(56) Documents cités:
- EP-A2- 0 028 916
- US-A- 5 303 201

## Description

La présente invention concerne les mémoires série sur microplaquette de silicium, et plus particulièrement la réalisation d'un plan mémoire étendu par juxtaposition d'une pluralité de mémoires série.

Les mémoires intégrées sur microplaquette de silicium présentent un plan mémoire intégré de taille limitée, généralement inférieure à l'espace mémoire que nécessitent certaines applications. Par exemple, les périphériques informatiques tels les imprimantes nécessitent des mémoires de grande capacité pour stocker de gros volumes de données. De ce fait, il est habituel de regrouper plusieurs microplaquettes de silicium pour former des plans mémoire étendus constitués par la juxtaposition des plans mémoire intégrés présents dans chacune des mémoires. Un tel regroupement consiste généralement en un empilement de microplaquettes de silicium dans un même boîtier ou un empilement de boîtiers comprenant chacun une microplaquette de silicium.

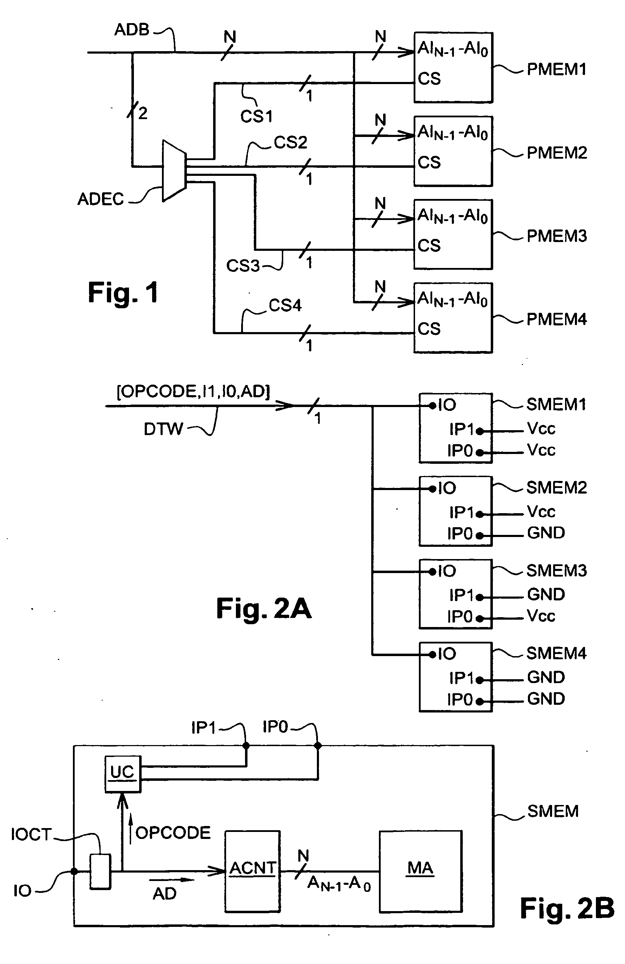

Les figures 1 et 2A, 2B illustrent deux procédés classiques permettant de réaliser un plan mémoire étendu, respectivement avec des mémoires de type parallèle et des mémoires série.

Sur la figure 1, quatre mémoires identiques PMEM1, PMEM2 PMEM3, PMEM4 de type à entrée/sortie parallèle sont regroupées pour obtenir un plan mémoire étendu. Les mémoires comprennent chacune un plan mémoire intégré adressable sous N bits (non représenté). Chaque mémoire comporte N entrées d'adresse AI₀-AI_{N-1} en parallèle, connectées aux N fils d'adresse de plus faible poids d'un bus d'adresse ADB. Le bus d'adresse comprend N+2 fils d'adresse, nécessaires à l'adressage du plan mémoire étendu dont la taille est ici quatre fois celle des plans mémoire intégrés dans les microplaquettes de silicium. La sélection de chaque mémoire au sein du plan mémoire étendu est faite au moyen d'une entrée de sélection CS ("Chip Select") prévue sur chaque microplaquette de silicium. A cet effet, les deux fils de plus fort poids du bus d'adresse ADB sont appliqués à un décodeur d'adresse ADEC qui fournit quatre fils de sélection CS1, CS2, CS3, CS4, chaque fil de sélection étant connecté à l'entrée CS d'une mémoire.

Cet exemple montre que la réalisation d'un plan mémoire étendu au moyen de circuits intégrés à entrées parallèles entraîne une démultiplication rédhibitoire des fils d'interconnexion afin de pouvoir sélectionner individuellement les mémoires au sein du plan mémoire étendu.

La figure 2A concerne plus spécifiquement le domaine technique de l'invention et représente un plan mémoire étendu réalisé avec quatre mémoires identiques SMEM1, SMEM2, SMEM3, SMEM4 à entrée/sortie série, ou mémoires série, dont la structure est représentée schématiquement en figure 2B.

Chaque mémoire SMEM comprend une entrée/sortie série IO, un circuit d'entrée/sortie IOCT, une unité centrale UC, un compteur d'adresse ACNT de N bits et un plan mémoire intégré MA adressable sous N bits (fig. 2B). Le circuit IOCT est relié à l'entrée/sortie série IO et transforme des données reçues sous forme série en données parallèles, et inversement. Chaque entrée/sortie série IO est connectée à un fil de données DTW (fig. 2A) commun à toutes les mémoires, qui véhicule à la fois des commandes, des adresses et des données sous forme série. Chaque mémoire comprend également deux entrées IP1, IP0 dont le potentiel électrique est ajusté de manière à attribuer à chaque mémoire une adresse de poids fort déterminée. Par exemple, les deux entrées IP1, IP0 de la mémoire SMEM1 sont portées à une tension d'alimentation Vcc pour attribuer à la mémoire l'adresse de poids fort "11", les entrées IP1, IP0 de la mémoire SMEM2 sont portées respectivement à la tension Vcc et à la masse (GND) pour attribuer à la mémoire l'adresse de poids fort "10", les entrées IP1, IP0 de la mémoire SMEM3 sont portées à la masse et à la tension Vcc pour attribuer à la mémoire l'adresse de poids fort "01" et les entrées IP1, IP0 de la mémoire SMEM4 sont portées à la masse pour attribuer à la mémoire l'adresse de poids fort "00".

La sélection de chaque mémoire au sein du plan mémoire étendu est faite en envoyant aux mémoires des commandes du type [OPCODE, I1, I0, AD] comprenant un code opération OPCODE, deux bits I1, I0 formant une adresse de poids fort et une adresse AD de N bits formant une adresse de poids faible, l'adresse de poids fort formant avec l'adresse AD une adresse étendue. L'unité centrale de chaque mémoire exécute les codes opération OPCODE présents dans les commandes reçues si l'adresse de poids fort I1 I0 correspond à l'adresse de poids fort IP1 IP0 attribuée à la mémoire. Dans le cas d'une commande de lecture, le compteur d'adresse ACNT applique au plan mémoire MA les N bits d'adresse A_{N-1}A₀ présents dans la commande, tandis que l'unité centrale applique un signal de lecture au plan mémoire.

Les brevets US 5 303 201 et US 5 895 480 décrivent des mémoires du type précité, dans lesquelles le compteur d'adresse (un tampon d'adresse dans US 5 895 480) est un compteur d'adresse étendu (ou un tampon d'adresse étendue) pouvant recevoir une adresse étendue au lieu de ne recevoir que l'adresse de poids faible. Le fonctionnement de ces mémoires est sensiblement identique à celui de la mémoire décrite ci-dessus, en ce que l'adresse de poids fort reçue par le compteur ou tampon d'adresse est comparée à l'adresse de poids fort attribuée à la mémoire, et en ce qu'une commande de lecture n'est pas exécutée si l'adresse de poids fort présente dans une adresse étendue n'est pas identique à l'adresse de poids fort attribuée à la mémoire.

En résumé, le procédé classique d'obtention d'un plan mémoire étendu consiste à prévoir des mémoires capables de "s'auto-identifier" sur réception d'une commande comprenant une adresse étendue, et de ne pas exécuter la commande si l'adresse de poids fort incluse dans l'adresse étendue n'est pas identique à l'adresse de poids fort attribuée à la mémoire.

Ce procédé est avantageux en ce qui concerne le nombre d'interconnexions électriques, mais le plan mémoire étendu obtenu ne présente pas de caractère unitaire, par exemple en ce qui concerne l'exécution d'une commande de lecture continue. Ainsi, une lecture continue du plan mémoire étendu nécessite tout d'abord l'envoi à la première mémoire SMEM1 d'une commande de lecture continue de son plan mémoire intégré, une telle commande comprenant le code opération de la commande, l'adresse de poids fort 1,1 de la mémoire SMEM1, et l'adresse de poids faible AD0 désignant la zone mémoire où la lecture continue doit être initialisée dans le plan mémoire intégré. Des commandes similaires ayant des bits d'identification appropriés doivent ensuite être envoyées aux autres mémoires, soit au total quatre commandes pour lire l'ensemble du plan mémoire étendu.

Ainsi, un objectif général de la présente invention est de prévoir un procédé et une structure de mémoire série qui permettent de réaliser un plan mémoire étendu ayant un caractère unitaire, c'est-à-dire se comportant, vu de l'extérieur, comme une mémoire unique comprenant un plan mémoire de grande taille.

Un objectif plus particulier de l'invention est de prévoir un plan mémoire étendu présentant un caractère unitaire en ce qui concerne l'exécution d'une commande de lecture continue du plan mémoire.

Un objectif plus particulier de l'invention est de prévoir un plan mémoire étendu présentant un caractère unitaire en ce qui concerne l'exécution de commandes particulières visant à lire des registres spéciaux qui sont généralement prévus dans les mémoires série, par exemple des registres d'état ou des registres d'identification.

Un objectif plus particulier de l'invention est de prévoir un plan mémoire étendu présentant un caractère unitaire en ce qui concerne la protection du plan mémoire étendu en lecture et en écriture lorsqu'une mémoire est en train de réaliser une opération d'écriture.

Au moins un objectif de l'invention est atteint par la prévision d'une mémoire sur microplaquette de silicium comprenant une entrée/sortie série, des moyens pour mémoriser une adresse de poids fort attribuée à la mémoire au sein d'un plan mémoire étendu adressable au moyen d'une adresse étendue comprenant une adresse de poids faible et une adresse de poids fort, un plan mémoire intégré adressable avec l'adresse de poids faible, au moins un registre accessible en lecture, des moyens pour fournir un signal de mémoire maître présentant une valeur active ou une valeur inactive, à partir de l'adresse de poids fort attribuée à la mémoire, le signal de mémoire maître à la valeur active signifiant que la mémoire est maître au sein du plan mémoire étendu, le signal de mémoire maître à la valeur inactive signifiant que la mémoire est esclave au sein du plan mémoire étendu, et une unité centrale pour exécuter une commande de lecture du registre et de fourniture du contenu du registre sur l'entrée/sortie série de la mémoire, uniquement si la mémoire est mémoire maître au sein du plan mémoire étendu.

Selon un mode de réalisation, la mémoire comprend des moyens pour mémoriser une information sur la taille du plan mémoire étendu, et des moyens pour fournir le signal de mémoire maître à partir de l'adresse de poids fort attribuée à la mémoire et de l'information sur la taille du plan mémoire étendu.

Selon un mode de réalisation, l'information sur la taille du plan mémoire étendu comprend le nombre de bits que comprend l'adresse de poids fort présente dans une adresse étendue.

Selon un mode de réalisation, le signal de mémoire maître est porté à la valeur active si l'adresse de poids fort attribuée à la mémoire est la plus forte adresse de poids fort attribuée au sein du plan mémoire étendu.

Selon un mode de réalisation, le registre est un registre d'état comprenant des bits de protection en écriture du plan mémoire étendu.

Selon un mode de réalisation, le registre est un registre d'identification comprenant une donnée d'identification de la mémoire.

Selon un mode de réalisation, l'unité centrale est configurée pour exécuter une commande d'écriture du registre quelle que soit la valeur du signal de mémoire maître.

Selon un mode de réalisation, les moyens pour fournir un signal de mémoire maître comprennent un circuit de décodage recevant en entrée l'information sur la taille du plan mémoire étendu et l'adresse de poids fort attribuée à la mémoire.

Selon un mode de réalisation, la mémoire comprend un compteur d'adresse étendue pour mémoriser une adresse étendue reçue sur l'entrée/sortie série de la mémoire, des moyens pour comparer l'adresse de poids fort de l'adresse étendue avec l'adresse de poids fort attribuée à la mémoire, et des moyens pour empêcher l'exécution d'une commande de lecture ou d'écriture du plan mémoire intégré si l'adresse de poids fort de l'adresse étendue est différente de l'adresse de poids fort attribuée à la mémoire.

Selon un mode de réalisation, la mémoire comprend un circuit tampon de sortie pour fournir sur l'entrée/sortie série de la mémoire des données lues dans le plan mémoire intégré, et un comparateur pour fournir un signal de blocage du circuit tampon de sortie si l'adresse de poids fort de l'adresse étendue est différente de l'adresse de poids fort attribuée à la mémoire.

Selon un mode de réalisation, la mémoire comprend des contacts spécifiques permettant de configurer l'adresse de poids fort attribuée à la mémoire, en appliquant des potentiels électriques déterminés sur chacun des contacts spécifiques.

La présente invention concerne également un procédé pour la réalisation d'un plan mémoire étendu adressable au moyen d'une adresse étendue comprenant une adresse de poids faible et une adresse de poids fort, le plan mémoire étendu comprenant une pluralité de mémoires série intégrées sur microplaquettes de silicium, chaque mémoire comprenant une entrée/sortie série, un plan mémoire intégré adressable avec l'adresse de poids faible, et au moins un registre accessible en lecture après application à la mémoire d'une commande de lecture du registre, les entrées/sorties série des mémoires étant interconnectées, le procédé comprenant les étapes consistant à attribuer à chaque mémoire une adresse de poids fort au sein du plan mémoire étendu, désigner, dans le plan mémoire étendu, une seule mémoire maître et des mémoires esclaves, et configurer les mémoires de manière que seule la mémoire maître exécute une commande de lecture du registre, et que les mémoires esclaves n'exécutent pas une telle commande.

Selon un mode de réalisation, le procédé comprend les étapes consistant à prévoir, dans chaque mémoire, des moyens pour mémoriser l'adresse de poids fort attribuée à la mémoire, des moyens pour fournir un signal de mémoire maître présentant une valeur active ou une valeur inactive, à partir de l'adresse de poids fort attribuée à la mémoire, le signal de mémoire maître à la valeur active signifiant que la mémoire est maître au sein du plan mémoire étendu, le signal de mémoire maître à la valeur inactive signifiant que la mémoire est esclave au sein du plan mémoire étendu, et une unité centrale pour exécuter une commande de lecture du registre et de fourniture du contenu du registre sur l'entrée/sortie série de la mémoire, uniquement si la mémoire est mémoire maître au sein du plan mémoire étendu.

Selon un mode de réalisation, le procédé comprend les étapes consistant à prévoir, dans chaque mémoire, des moyens pour mémoriser une information sur la taille du plan mémoire étendu, et des moyens pour fournir le signal de mémoire maître à partir de l'adresse de poids fort attribuée à la mémoire et de l'information sur la taille du plan mémoire étendu.

Selon un mode de réalisation, l'information sur la taille du plan mémoire étendu comprend le nombre de bits de poids fort présents dans une adresse étendue appliquée au plan mémoire.

Selon un mode de réalisation, chaque mémoire fournit le signal de mémoire maître au moyen d'un circuit de décodage de l'information sur la taille du plan mémoire étendu et de l'adresse de poids fort attribuée à la mémoire.

Selon un mode de réalisation, une mémoire est mémoire maître si elle se voit attribuer la plus forte adresse de poids fort au sein du plan mémoire étendu.

Selon un mode de réalisation, le registre est un registre d'état comprenant des bits de protection en écriture du plan mémoire étendu.

Selon un mode de réalisation, le registre est un registre d'identification comprenant une donnée d'identification de la mémoire.

Selon un mode de réalisation, une commande d'écriture du registre est exécutée par toutes les mémoires.

Ces objets, caractéristiques et avantages ainsi que d'autres de la présente invention seront exposés plus en détail dans la description suivante d'une mémoire selon l'invention, faite à titre non limitatif en relation avec les figures jointes parmi lesquelles :
- la figure 1 précédemment décrite représente un plan mémoire étendu comprenant des mémoires de type parallèle,
- les figures 2A, 2B précédemment décrites représentent respectivement un plan mémoire étendu comprenant des mémoires série classiques et la structure de ces mémoires série,
- la figure 3 représente un plan mémoire étendu comprenant des mémoires série selon l'invention, et représente schématiquement la structure de l'une de ces mémoires série,
- la figure 4 représente sous forme de blocs un exemple de réalisation d'une mémoire série selon l'invention,
- la figure 5A représente un premier exemple de réalisation d'un compteur d'adresse étendue représenté sous forme de bloc en figure 4,
- la figure 5B représente un premier exemple de réalisation d'un comparateur représenté sous forme de bloc en figure 4,
- la figure 6A représente un second exemple de réalisation du compteur d'adresse étendue représenté sous forme de bloc en figure 4,
- la figure 6B représente un second exemple de réalisation du comparateur représenté sous forme de bloc en figure 4,
- les figures 7A à 7J sont des chronogrammes représentant des signaux de comptage et des signaux de données et illustrant le fonctionnement d'un plan mémoire étendu selon l'invention en réponse à une commande de lecture continue.

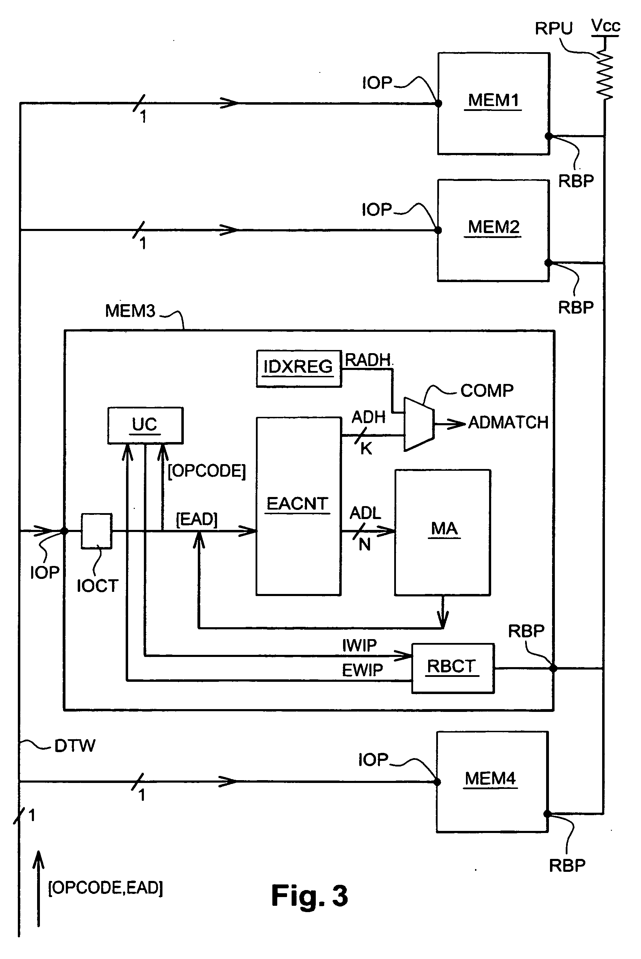

La figure 3 représente un plan mémoire étendu comprenant quatre mémoires série MEM1, MEM2, MEM3, MEM4 selon l'invention, intégrées sur des microplaquettes de silicium. Chaque mémoire comprend classiquement un contact d'entrée/sortie série IOP (In/Out Pad), un circuit d'entrée/sortie IOCT assurant la conversion des données reçues sous forme série en données parallèles, et inversement, un plan mémoire intégré MA adressable sous N bits, et une unité centrale UC à logique câblée ou à microprocesseur. On supposera ici et dans ce qui suit, dans un souci de simplicité de l'exposé, que les plans mémoire intégrés de chaque mémoire sont identiques et que le nombre N de bits d'adresse nécessaire à la lecture ou à l'écriture d'une donnée dans chacun des plans mémoire intégrés est identique pour chaque mémoire.

Les mémoires MEM1 à MEM4 ont leurs contacts IOP respectifs reliés à un fil de données DTW commun. Ce fil de données appartient à un bus de données série pouvant comprendre des fils de contrôle comme des fils d'horloge, d'alimentation, de masse... qui ne sont pas représentés ici.

Selon l'invention, les commandes de lecture ou d'écriture envoyées aux mémoires via le fil DTW comprennent un code opération OPCODE, une adresse EAD, et éventuellement une donnée DT (pour les commandes d'écriture de données), soit :
[OPCODE, EAD] (lecture)
   ou
[OPCODE, EAD, DT] (écriture)

L'adresse EAD est une adresse étendue comprenant un nombre N+K de bits d'adresse qui est supérieur au nombre N de bits d'adresse que nécessite l'adressage du plan mémoire intégré de chaque mémoire, N+K étant au moins égal au nombre de bits d'adresse que nécessite l'adressage du plan mémoire étendu considéré dans son ensemble. L'adresse étendue EAD comprend ainsi N bits d'adresse de poids faible A_{N-1}-A₀ formant une adresse de pois faible ADL destinée à sélectionner une zone mémoire dans l'un des plans mémoire intégrés, généralement un mot binaire, et K bits d'adresse de poids fort A_{N+K-1}, A_{N+K-2}, ... A_{N} formant une adresse de poids fort ADH permettant de désigner l'une des mémoires.

Dans l'exemple représenté, K est égal à 2 car le plan mémoire étendu comprend quatre mémoires série. Les commandes comportent ainsi des adresses de N+2 bits. L'adresse ADL comprend des bits d'adresse de poids faible A_{N-1}-A₀ et l'adresse ADH comprend 2 bits d'adresse de poids fort A_{N+1}, A_{N}.

Chaque mémoire comprend un compteur d'adresse étendue EACNT de N+K bits, ici N+2 bits, un comparateur COMP ayant deux fois K entrées (2*K), ici 4 entrées, et un moyen de mémorisation d'une adresse de poids fort de référence RADH attribuée à la mémoire, qui représente l'adresse de la mémoire au sein du plan mémoire étendu, plus précisément l'adresse du plan mémoire intégré de la mémoire au sein du plan mémoire étendu.

Ce moyen de mémorisation est par exemple un registre d'indexation IDXREG comprenant K bits de référence R_{K-1}, R_{K-2}, ...R₀, ici deux bits R1, R0, représentant l'adresse RADH. Par exemple, le registre IDXREG de la mémoire MEM1 comprend les bits de référence "00", le registre IDXREG de la mémoire MEM2 comprend les bits de référence "01", le registre IDXREG de la mémoire MEM3 comprend les bits de référence "10" et le registre IDXREG de la mémoire MEM4 comprend les bits de référence "11".

Lorsqu'une commande comprenant une adresse étendue est envoyée sur le fil de données DTW, chaque mémoire reçoit la commande et applique le code opération OPCODE à son unité centrale UC, et enregistre l'adresse étendue EAD dans son compteur d'adresse étendue EACNT. L'adresse ADL formée par les N premiers bits A_{N-1}-A₀ de l'adresse EAD mémorisée par le compteur, est appliquée au plan mémoire MA tandis que l'adresse ADH, formée par les K bits d'adresse de poids fort de l'adresse EAD, ici-les bits A_{N+1}, A_{N}, est appliquée sur K premières entrées du comparateur COMP, ici deux entrées. Ce dernier reçoit sur K autres entrées, ici deux entrées, les bits de référence R_{K-1}-R₀, ici les bits R1, R0.

La sortie du comparateur fournit un signal ADMATCH qui est par exemple à 1 lorsque les bits de poids fort de l'adresse étendue reçue sont identiques à l'adresse de poids fort attribuée à la mémoire, c'est-à-dire identiques aux bits de référence. Le signal ADMATCH est utilisé pour empêcher les mémoires qui ne sont pas concernées par l'adresse étendue d'exécuter la commande reçue, qu'il s'agisse d'une commande de lecture ou d'une commande d'écriture (quand les plans mémoire intégrés sont accessibles en écriture).

La non-exécution d'une commande d'écriture est obtenue classiquement en bloquant l'exécution du code opération par l'unité centrale UC, en ce qui concerne les commandes d'écriture.

Selon l'invention, la non-exécution d'une commande de lecture est obtenue en laissant l'unité centrale de chaque mémoire exécuter l'opération de lecture tout en empêchant les données lues d'être appliquées sur le contact d'entrée/sortie série IOP. Cette méthode permet avantageusement d'assurer une lecture continue du plan mémoire étendu, car elle permet de laisser l'unité centrale de chaque mémoire lire en permanence son plan mémoire intégré, et de fournir les données lues lorsque le signal ADMATCH passe à 1.

Selon un autre aspect de l'invention, chaque mémoire comprend un contact de disponibilité/occupation RBP (Ready/Busy Pad) et un circuit RBCT de gestion du contact RBP. Les contacts RBP des mémoires sont interconnectés et sont portés par défaut à un potentiel haut, ici une tension d'alimentation Vcc, par l'intermédiaire d'une résistance tire-haut RPU de forte valeur. La résistance RPU est ici externe aux mémoires, mais peut également être interne à chaque mémoire, c'est-à-dire être intégrée sur les microplaquettes de silicium.

Le circuit RBCT reçoit un signal IWIP (Internal Write In Progress) émis par l'unité centrale, et fournit à l'unité centrale un signal EWIP (External Write In Progress). Le signal IWIP est mis à 1 par l'unité centrale pendant une opération d'écriture du plan mémoire intégré (effacement et/ou programmation). Lorsque le signal IWIP passe à 1, le circuit RBCT force le contact RBP à un potentiel bas, par exemple le potentiel de masse. Par ailleurs le circuit RBCT met à 1 le signal EWIP lorsqu'il détecte le potentiel bas, ici le potentiel de masse, sur le contact RBP, y compris lorsque le signal IWIP est à 0. Le fait que le signal EWIP soit à 1 alors que le signal IWIP est à 0 signifie que le potentiel de masse sur le contact RBP est imposé par une autre mémoire. Le signal EWIP permet ainsi à l'unité centrale de savoir qu'une mémoire du plan mémoire étendu est en train d'effectuer une opération d'écriture dans le plan mémoire qui lui est propre. L'unité centrale refuse alors d'exécuter une commande de lecture ou d'écriture pouvant éventuellement être reçue sur le contact d'entrée/sortie IOP, tant que l'écriture en cours n'est pas terminée.

Ainsi, lorsqu'une mémoire exécute une opération d'écriture, les autres mémoires en sont informées par le passage à 0 de leur contact RBP, qui entraîne le passage à 1 du signal EWIP. Les unités centrales de ces mémoires refusent alors d'exécuter des commandes en lecture ou en écriture. Cet aspect de l'invention permet de conférer au plan mémoire étendu un caractère unitaire en écriture, puisque celui-ci se comporte alors, vu de l'extérieur, comme une mémoire unique. En effet, une mémoire unique ne peut exécuter simultanément une opération d'écriture et de lecture de son plan mémoire. De même, une mémoire unique ne peut exécuter simultanément deux commandes d'écriture dans deux zones différentes de son plan mémoire. C'est donc le comportement d'une mémoire unique qui est recréé au sein du plan mémoire étendu, considéré comme un tout indivisible.

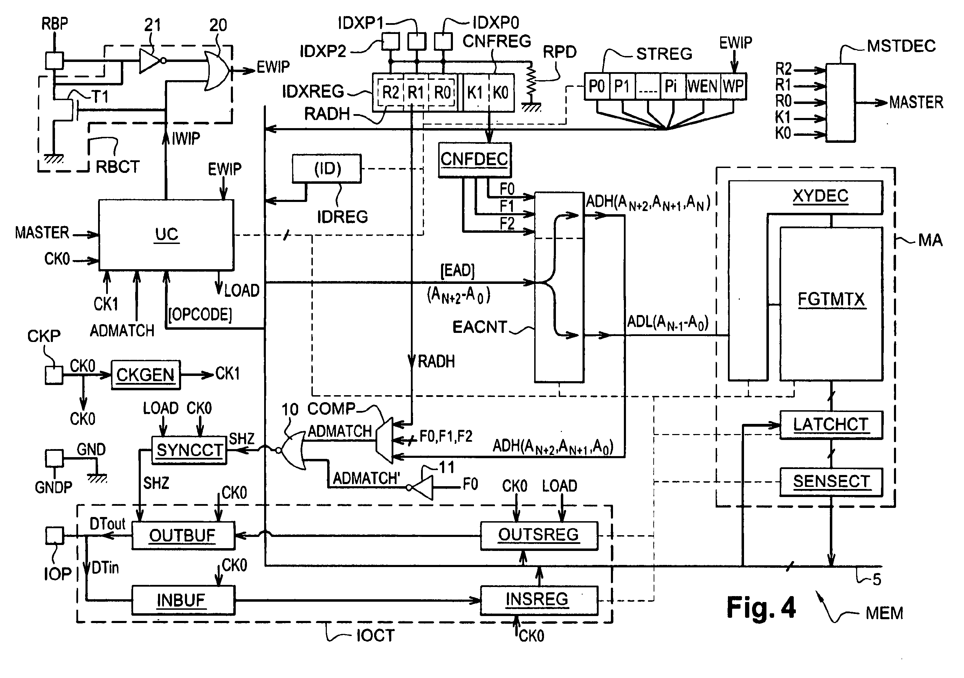

On décrira maintenant en relation avec la figure 4 un mode de réalisation détaillé d'une mémoire série mettant en oeuvre les divers aspects de l'invention mentionnés ci-dessus, ainsi que d'autres qui seront décrits par la suite.

### Aspects généraux de la mémoire

La mémoire MEM représentée en figure 4 comprend les éléments décrits plus haut, à savoir :
- le contact IOP formant l'entrée/sortie série de la mémoire,
- le contact de disponibilité/occupation RBP,
- le circuit d'entrée/sortie IOCT,
- le circuit RBCT de gestion du contact RBP,
- l'unité centrale UC,
- le compteur d'adresse étendue EACNT,
- le plan mémoire MA adressable sous N bits,
- le registre d'indexation IDXREG, et
- le comparateur COMP.
La mémoire comprend également :
- un bus de données interne 5 de type parallèle,
- un contact de masse GNDP,
- un contact d'horloge CKP recevant un signal d'horloge CK0,
- un circuit d'horloge CKGEN,
- un circuit de synchronisation SYNCCT, et
- deux registres spéciaux, ici un registre d'état STREG (Statuts Register) et un registre d'identification IDREG.

Le circuit d'entrée/sortie comprend un tampon d'entrée INBUF ayant une entrée et une sortie série, un registre à décalage INSREG ayant une entrée série et une sortie parallèle, un tampon de sortie OUTBUF ayant une entrée et une sortie série, et un registre à décalage OUTSREG ayant une entrée parallèle et une sortie série. Le tampon INBUF a son entrée reliée au contact IOP et sa sortie série reliée à l'entrée série du registre INSREG, dont la sortie est reliée au bus de données 5. Le registre OUTSREG a son entrée reliée au bus de données 5. Sa sortie est reliée à l'entrée du tampon OUTBUF dont la sortie est reliée au contact IOP.

Le plan mémoire MA comprend une matrice de cellules mémoire FGTMTX, par exemple une matrice de transistors à grille flottante, un décodeur de ligne et de colonne XYDEC, un circuit de programmation LATCHCT comprenant des verrous haute tension dont les entrées sont reliées au bus 5, et un circuit de lecture SENSECT comprenant des amplificateurs de lecture dont les sorties sont reliées au bus 5.

Les registres spéciaux STREG et IDREG sont accessibles en lecture et en écriture via le bus de données 5. Le registre IDREG comprend par exemple un identifiant unique ID de la microplaquette de silicium. Le registre d'état STREG comprend par exemple des bits P0, P1, ...Pi de protection en écriture de fractions (parties) du plan mémoire, un bit WEN de protection générale en écriture (Write Enable), ainsi qu'un bit WP représentatif de la valeur courante du signal EWIP, et de façon générale toute donnée utile à la gestion d'une mémoire connue de l'homme de l'art.

L'unité centrale contrôle les divers éléments de la mémoire, les liaisons de contrôle entre l'unité centrale et ces divers éléments étant représentées schématiquement par un trait pointillé. L'unité centrale contrôle notamment les divers registres en lecture et/ou écriture, contrôle en lecture et écriture le plan mémoire MA et ses éléments constitutifs, contrôle le compteur d'adresse étendue EACNT pour le chargement de l'adresse étendue et/ou pour l'incrémentation ou la décrémentation du compteur, lors de l'exécution de commandes de lecture continue, contrôle le chargement des registres à décalage, etc..

Le générateur d'horloge CKGEN fournit un signal d'horloge CK1 qui est un sous-multiple du signal CK0. Le signal CK0 est un signal d'horloge bit tandis que le signal CK1 est un signal d'horloge mot, dont la fréquence est égale à la fréquence du signal d'horloge CK0 divisée par le nombre de bits que comprennent les mots binaires présents dans le plan mémoire. Le signal d'horloge CK1 cadence les opérations portant sur des mots binaires, notamment de lecture ou d'écriture du plan mémoire, d'incrémentation ou de décrémentation du compteur d'adresse EACNT, de chargement d'un mot binaire dans le registre OUTSREG ou de lecture d'un mot binaire dans le registre INSREG, etc.. Le signal d'horloge CK0 cadence les opérations liées à la transmission ou à la réception de bits sous forme série, notamment le décalage de bits dans les registres à décalage OUTSREG, INSREG et le cadencement des tampons OUTBUF, INBUF.

On décrira maintenant des aspects de l'invention relatifs à l'exécution de commandes comprenant une adresse étendue

### Exécution de commandes comprenant une adresse étendue

Les codes opération OPCODE et les adresses étendues EAD reçus sous forme série sur le contact IOP sont transformés par le registre INSREG en données parallèle appliquées sur le bus 5, et sont respectivement appliqués sur une entrée de l'unité centrale et une entrée du compteur d'adresse étendue EACNT. Lorsqu'une adresse EAD a été enregistrée dans le compteur d'adresse EACNT, celui-ci fournit les N premiers bits d'adresse A_{N-1}-A₀ (adresse ADL) au décodeur XYDEC, et fournit les bits d'adresse de poids fort A_{N+2}, A_{N+1}, A_{N}, (adresse ADH) à des premières entrées du comparateur COMP.

Le registre d'indexation IDXREG comprend ici trois bits de référence R2, R1, R0 qui forment l'adresse de poids fort de référence RADH attribuée à la mémoire au sein du plan mémoire étendu. Ce plan mémoire étendu est ainsi adressable au maximum sous N+3 bits (K=3), et sa taille ne peut être supérieure ici à 8 fois la taille du plan mémoire intégré MA. Une adresse étendue comprend, ainsi ici, au maximum, 3 bits d'adresse de poids fort A_{N+2}, A_{N+1}, A_{N}.

Les bits R2, R1, R0 sont appliqués sur des secondes entrées du comparateur COMP dont la sortie fournit le signal ADMATCH décrit plus haut.

Le signal ADMATCH est appliqué à l'unité centrale pour bloquer l'exécution de commandes d'écriture. Le signal ADMATCH est également appliqué sur une entrée d'une porte 10 de type NON OU à deux entrées, dont la sortie fournit un signal SHZ (Set High Z). Le signal SHZ est appliqué sur une entrée de commande du tampon de sortie OUTBUF par l'intermédiaire du circuit de synchronisation SYNCCT. Le tampon de sortie OUTBUF est un tampon trois états pouvant présenter un état de sortie à 0 (masse), à 1 (Vcc) ou à haute impédance (HZ). Lorsque le signal SHZ est à 1, le tampon OUTBUF met sa sortie à haute impédance. Le circuit de synchronisation SYNCCT est généralement transparent pour le signal SHZ, sauf dans un cas particulier décrit ci-après.

Ainsi, lorsque les bits de poids fort présents dans une adresse étendue reçue dans une commande ne correspondent pas avec les bits de référence, le signal ADMATCH passe à 0 et le signal SHZ passe à 1, ce qui fait basculer la sortie du tampon OUTBUF dans l'état haute impédance. Les données appliquées sur l'entrée série du tampon ne sont donc plus transmises sur le contact d'entrée/sortie IOP, ce qui permet de ne pas exécuter une commande de lecture. L'unité centrale, quant à elle, est configurée pour exécuter la commande de lecture, conformément à la méthode selon l'invention pour ne pas exécuter une commande de lecture, selon laquelle les données sont lues mais bloquées en sortie.

Le circuit SYNCCT devient non transparent vis-à-vis du signal SHZ quand un signal LOAD de chargement d'un mot binaire est appliqué au registre à décalage OUTSREG par l'unité centrale. A partir de cet instant, le circuit SYNCCT compte un nombre de cycles d'horloge CK0 correspondant au nombre de bits présents dans un mot binaire, soit un cycle d'horloge CK1, et redevient transparent lorsque le cycle d'émission du mot binaire est terminé. Ainsi, si le signal SHZ passe à 1 alors qu'un mot binaire est en train d'être envoyé bit à bit sur le contact de sortie IOP, le blocage (mise à haute impédance) du tampon de sortie ne se produit qu'après que l'intégralité du mot a été envoyée.

On décrira maintenant les aspects de l'invention relatifs à la protection en lecture du plan mémoire étendu pendant une opération d'écriture.

### Protection du plan mémoire étendu pendant une écriture

Le circuit RBCT comprend un transistor interrupteur T1, ici de type NMOS, une porte 20 de type OU et une porte inverseuse 21. Les bornes de drain et de source du transistor T1 sont connectées respectivement au contact RBP et à la masse, tandis que la grille du transistor est pilotée par le signal IWIP fourni par l'unité centrale. La porte 21 est connectée en entrée au contact RBP. La porte 20 reçoit sur une entrée le signal IWIP, sur une autre entrée la sortie de la porte 21, et sa sortie fournit le signal EWIP.

Comme indiqué plus haut, le signal IWIP est mis à 1 lorsque l'unité centrale procède à une opération d'effacement et/ou de programmation dans le plan mémoire. Le contact RBP, qui est polarisé à la tension Vcc par la résistance RPU décrite précédemment, est alors forcé à 0 (masse) par le transistor T1. Par ailleurs, si le contact RBP est forcé à 0 par une autre mémoire (les contacts RBP étant interconnectés), le signal EWIP passe à 1 même si le signal IWIP est à 0. Ainsi, quand IWIP=0 et EWIP=1, l'unité centrale sait qu'une autre mémoire est en cours d'écriture et refuse d'exécuter une commande de lecture ou écriture, pour les raisons exposées plus haut.

On décrira maintenant des aspects de l'invention permettant d'obtenir une mémoire série qui est configurable et peut s'incorporer dans un plan mémoire étendu de taille variable.

### Réalisation d'une mémoire configurable

La mémoire comprend un registre de configuration CNFREG et un décodeur de configuration CNFDEC. Le registre CNFREG comprend une information sur la taille du plan mémoire étendu dans lequel la mémoire est incorporée. Cette information est ici le nombre K qui est codé en binaire au moyen de deux bits K1, K0, et peut varier entre K=0 et K=Kmax=3. La taille du plan mémoire étendu est ainsi égale à 2^{K} fois la taille du plan mémoire intégré MA, soit un nombre de points mémoire (mots binaires) égal à 2^{K}*2^{N} ou 2^{N+K}.

La sortie du registre CNFREG est appliquée au décodeur de configuration CNFDEC qui fournit, à partir de K, trois drapeaux F2, F1, F0 indiquant le nombre de bits d'adresse de poids fort que comprend l'adresse étendue du plan mémoire étendu.

A noter que les drapeaux F2, F1, F0 peuvent également être directement enregistrés dans le registre CNFREG, la mémorisation du paramètre K sous forme binaire étant prévue ici pour réduire la taille du registre CNFREG.

La relation entre le nombre K et les drapeaux F2, F1, F0 est décrite par le tableau 1 ci-après. La valeur décimale de K est décrite par la première colonne du tableau. La valeur binaire de K (bits K1, K0) est décrite par la deuxième colonne. La taille du plan mémoire étendu est décrite par la troisième colonne du tableau. Les quatrième, cinquième et sixième colonnes décrivent respectivement les valeurs des drapeaux F2, F1, F0 pour chaque valeur de K. La septième colonne mentionne les bits d'adresse de poids fort (bits d'adresse au-delà des N premiers bits) que comprend l'adresse étendue, pour chaque valeur de K. La dernière colonne décrit la valeur maximale MSBmax de l'adresse de poids fort dans le plan mémoire étendu, pour chaque valeur de K.

Il apparaît dans le tableau 1 qu'un drapeau F2, F1, F0 est à 1 lorsque le bit de poids fort correspondant est utilisé dans l'adresse étendue. Ainsi, K est une variable programmable qui peut varier de 0 à Kmax, avec ici Kmax=3, et le registre de configuration permet d'incorporer la mémoire dans un plan mémoire étendu comprenant 2 (K=1), 4 (K=2) ou 8 (K=3) mémoires ayant un plan mémoire intégré adressable sous N bits, ou de l'incorporer dans un plan mémoire étendu composite (composé de mémoires de tailles différentes) adressable sous N+K bits.

Il apparaît également dans le tableau 1 que le drapeau F0 est à 0 uniquement quand K est égal à 0. En d'autres termes, le fait que le drapeau F0 soit à 0 signifie que la mémoire n'est pas intégrée dans un plan mémoire étendu, et qu'il n'existe pas d'adresse de poids fort. La mémoire fonctionne alors en mode "classique", c'est-à-dire en exécutant toutes les commandes sans que son fonctionnement dépende de la comparaison des bits d'adresse de poids fort et des bits de référence R2, R1, R0. Tableau 1

| K_{(décimal)} | K1 K0 | 2^{K}*2^{N} | F2 | F1 | F0 | MSB | MSBmax |
|---|---|---|---|---|---|---|---|
| 0 | 00 | 2^{N} | 0 | 0 | 0 | - | - |
| 1 | 01 | 2*2^{N} | 0 | 0 | 1 | A_{N} | 1 |
| 2 | 10 | 4*2^{N} | 0 | 1 | 1 | A_{N+1} A_{N} | 11 |
| 3 | 11 | 8*2^{N} | 1 | 1 | 1 | A_{N+2} A_{N+1} A_{N} | 111 |

Afin d'inhiber le mécanisme de comparaison des adresses de poids fort et des bits de référence quand F0=0, le drapeau F0 est appliqué à l'entrée d'une porte inverseuse 11 dont la sortie fournit un signal ADMATCH'. Le signal ADMATCH' est appliqué sur la deuxième entrée de la porte 10. Ainsi, lorsque F0=0, ADMATCH' est à 1 et le signal SHZ est forcé à 0, de sorte que le tampon OUTBUF ne peut pas être mis dans l'état haute impédance.

D'autre part, afin d'adapter le fonctionnement de la mémoire au nombre K de bits de poids fort que comprend l'adressage étendu, le compteur d'adresse étendue et/ou le comparateur présentent une configuration variable qui est fonction de K.

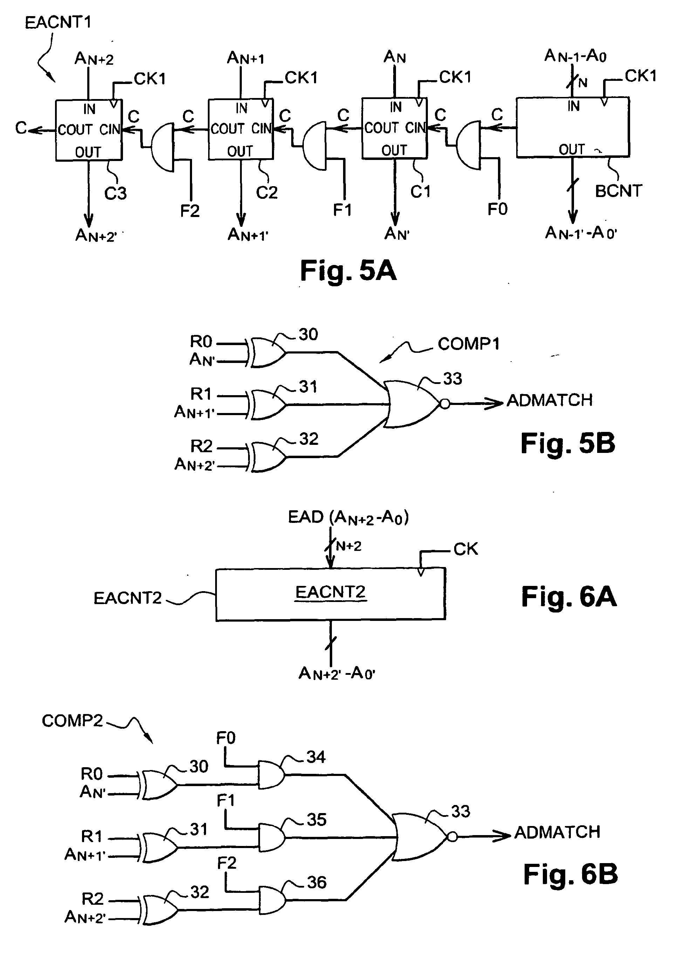

Les figures 5A et 5B représentent respectivement un premier mode de réalisation EACNT1 du compteur d'adresse étendue et un premier mode de réalisation COMP1 du comparateur. Selon ce premier mode de réalisation de ces éléments, le compteur d'adresse comprend un nombre variable de cellules de comptage actives, qui est fonction de K, tandis que le comparateur comprend un nombre d'entrées de comparaison qui est fixe et égal à Kmax.

Plus particulièrement, le compteur d'adresse EACNT1 comprend un bloc de comptage de base BCNT comprenant N cellules de comptage de 1 bit chacune (non représentées) et trois cellules de comptage supplémentaires C1, C2, C3 de 1 bit chacune, agencées à l'extérieur du bloc de comptage de base. Les diverses cellules de comptage sont cadencées par le signal d'horloge CK1.

Le bloc de comptage de base BCNT reçoit en entrée les bits d'adresse A_{N-1},-A₀, soit l'adresse ADL, et fournit des bits d'adresse A_{N-1}'-A₀'. Les bits d'adresse A_{N-1}' -A₀' sont égaux aux bits d'adresse reçus en entrée dans le cas d'une commande de lecture ou d'écriture à adresse fixe, ou forment une adresse incrémentée ou décrémentée au rythme du signal d'horloge CK1 dans le cas d'une commande de lecture continue. Le bloc de comptage BCNT fournit un bit de report de somme C (Carry) lorsqu'il atteint la valeur de débordement (tous les bits d'adresse à 1) et au moment où il repasse à 0.

Les cellules de comptage C1, C2, C3 comprennent chacune une entrée In pour recevoir un bit d'adresse de poids fort, respectivement A_{N}, A_{N+1}, A_{N+2}, formant ensemble l'adresse ADH, et une sortie fournissant des bits d'adresse A_{N}', A_{N+1}', A_{N+2}', respectivement. Chaque cellule de comptage C1, C2, C3 comprend une entrée CIN pour recevoir le bit C de rang précédent et une sortie COUT pour fournir le bit C de rang suivant. L'entrée CIN de la cellule C1 reçoit le bit C fournit par le bloc BCNT par l'intermédiaire d'une porte ET dont l'autre entrée reçoit le drapeau F0. L'entrée CIN de la cellule C2 reçoit le bit C fournit par la cellule C1 par l'intermédiaire d'une porte ET dont l'autre entrée reçoit le drapeau F1. L'entrée CIN de la cellule C3 reçoit le bit C fournit par la cellule C2 par l'intermédiaire d'une porte ET dont l'autre entrée reçoit le drapeau F2. Lorsque les drapeaux F0, F1, F2 sont à 1 (K=Kmax=3) les trois cellules sont actives et connectées en cascade au bloc BCNT. Les bits d'adresse A_{N}', A_{N+1}', A_{N+2}' sont alors égaux aux bits d'adresse reçus en entrée dans le cas d'une commande de lecture ou écriture à adresse fixe, ou forment une adresse de poids fort incrémentée ou décrémentée au rythme du signal d'horloge CK1 dans le cas d'une commande de lecture continue. Lorsque le drapeau F2 est à 0 et que les drapeaux F1, F0 à 1 (K=2), la cellule C3 est déconnectée du reste du compteur par la porte ET correspondante. Sa sortie reste à 0 pendant un cycle de lecture continue et n'intervient pas dans la détermination du signal ADMATCH fournit par le comparateur. Lorsque les drapeaux F2, F1 sont à 0 et le drapeau F0 à 1 (K=1), les cellules C3, C2 sont déconnectées du reste du compteur d'adresse et leurs sorties restent à 0 pendant un cycle de lecture continue et n'interviennent pas dans la détermination du signal ADMATCH fournit par le comparateur. Enfin, lorsque les drapeaux F0 à F2 sont tous à 0, les trois cellules sont déconnectées et le compteur d'adresse ne comprend que le compteur de base BCNT, qui est équivalent à un compteur d'adresse d'une mémoire classique. _La mémoire fonctionne dans ce cas en mode "classique": le signal ADMATCH' est à 1 et force à 0 le signal SHZ, comme décrit plus haut.

Le comparateur COMP1 représenté sur la figure 5B comprend des portes 30, 31, 32 de type OU EXCLUSIF et une porte 33 de type NON OU. La porte 30 reçoit en entrée le bit de référence R0 et le bit d'adresse de poids fort A_{N}'. La porte 31 reçoit en entrée le bit de référence R1 et le bit d'adresse de poids fort A_{N+1}'. La porte 32 reçoit en entrée le bit de référence R2 et le bit d'adresse de poids fort A_{N+2}'. La porte 33 présente trois entrées reliées respectivement aux sorties des portes 30, 31, 32, et fournit le signal ADMATCH.

Les figures 6A et 6B représentent respectivement un second mode de réalisation EACNT2 du compteur d'adresse étendue et un second mode de réalisation COMP2 du comparateur. Selon ce second mode de réalisation, le compteur d'adresse EACNT2 comprend un nombre invariable N+Kmax de cellules de comptage actives. Le compteur EACNT2 est l'équivalent du compteur EACNT1 dans lequel les portes ET permettant de filtrer les bits de report de somme C sont supprimées et remplacées par des connexions directes.

Le comparateur COMP2 présente les mêmes portes que le comparateur COMP1 décrit ci-dessus, désignées par les mêmes références. Il comprend en outre des portes 34, 35, 36 de type ET. La porte 34 reçoit en entrée la sortie de la porte 30 et le drapeau F0. Sa sortie est appliquée sur la première entrée de la porte 33. La porte 35 reçoit en entrée la sortie de la porte 31 et le drapeau F1. Sa sortie est appliquée sur la deuxième entrée de la porte 33. La porte 36 reçoit en entrée la sortie de la porte 32 et le drapeau F2. Sa sortie est appliquée sur la troisième entrée de la porte 33. Ainsi, les entrées du comparateur sont inhibées par les drapeaux F0, F1, F2 lorsque ceux-ci sont à 0. Plus particulièrement, les entrées du comparateur correspondant aux entrées de la porte 30 sont inhibées lorsque le drapeau F0 est à 0. Les entrées du comparateur correspondant aux entrées des portes 30, 31 sont inhibées lorsque les drapeaux F0, F1 sont à 0. Enfin, toutes les entrées du comparateur sont inhibées lorsque tous les drapeaux F0, F1, F2 sont à 0, le signal ADMATCH étant alors forcé à 1. Ce mode de réalisation du comparateur permet de supprimer les portes 10, 11, le signal ADMATCH pouvant être directement appliqué au circuit SYNCCT.

En définitive, la mémoire série selon l'invention présente une configuration programmable lui permettant de fonctionner comme une mémoire série classique, ou d'être intégrée dans un plan mémoire étendu dont la taille est de 2 fois, 4 fois ou 8 fois la taille de son propre plan mémoire.

La programmation du registre de configuration CNFREG est de préférence faite par software, au moyen d'une commande spécifique que l'unité centrale exécute. Cette programmation peut être prévue lorsque toutes les mémoires sont interconnectées, car la valeur de K est la même pour toutes les mémoires. La programmation du registre d'indexation IDXREG doit, par contre, être assurée avant l'interconnexion des mémoires, car chaque mémoire doit recevoir une adresse de poids fort individuelle et l'exécution d'une commande individuelle d'écriture du registre IDXREG ne peut être envisagée tant qu'une d'adresse de poids fort n'y est pas inscrite. Le registre IDXREG peut par exemple être programmé lors de la fabrication des microplaquettes de silicium, lesquelles sont ensuite classées par lots, chaque lot correspondant à une adresse de poids fort. Cette solution va toutefois à l'encontre de la flexibilité recherchée. Selon l'invention, une solution plus avantageuse consiste à prévoir des contacts électriques, ici trois contacts IDXP0, IDXP1, IDXP2 reliés à des entrées du registre IDXREG correspondant respectivement aux bits de référence R0, R1, R2. Les contacts IDXP0, IDXP1, IDXP2 sont reliés à la masse par une résistance tire-bas RPD de forte valeur, individuelle ou collective. Lorsque la microplaquette de silicium est agencée dans un boîtier, chaque contact IDXP0, IDXP1, IDXP2 est connecté à la tension Vcc pour programmer à 1 du bit de référence correspondant, ou est laissé déconnecté pour programmer à 0 le bit de référence correspondant. Si aucun des trois contacts IDXP0, IDXP1, IDXP2 n'est connecté à la tension Vcc, tous les bits de référence sont à 0 et la mémoire fonctionne en mode "classique". Divers perfectionnements de ce principe de programmation statique par câblage peuvent être prévus par l'homme de l'art. Notamment, peut être prévu un circuit de contrôle permettant de déconnecter la résistance RPD des contacts IDXP0, IDXP1, IDXP2 lorsque le registre IDXREG est programmé, afin d'éviter qu'un courant de fuite ne circule en permanence dans la résistance RPD.

Le tableau 2 ci-après décrit les diverses adresses de poids fort pouvant être chargées dans le registre IDXREG en fonction de la valeur de K (K1 K0) chargée dans le registre CNFREG. Tableau 2

| CNFRBG (K1 K0) | IDXREG (R2 R1 R0) |
|---|---|
| 00 | 000 |
| 01 | 000 ou 001 |
| 10 | de 000 à 011 |
| 11 | de 000 à 111 |

On décrira maintenant un aspect de l'invention se rapportant à la lecture de l'un des registres spéciaux. Le but de l'invention est ici de faire en sorte que, lorsqu'une commande de lecture d'un tel registre est appliquée à un ensemble de mémoires, une seule mémoire traite la commande et fournit sur le bus série le contenu du registre spécial, afin d'éviter des collisions de réponses.

### Lecture de registres spéciaux

La mémoire comprend un décodeur de mémoire maître MSTDEC qui fournit un signal MASTER (Fig. 6). Lorsque le signal MASTER est à 1, la mémoire est considérée comme mémoire maître au sein du plan mémoire étendu tandis que les autres mémoires sont considérées comme esclaves. Une seule mémoire pouvant être maître au sein du même plan mémoire étendu, le signal MASTER doit être à 1 pour une seule mémoire. Selon l'invention, une solution parmi d'autres est de conférer le statut de mémoire maître à celle qui reçoit dans le registre IDXREG une adresse de poids fort qui est la plus forte adresse de poids fort du plan mémoire étendu. A cet effet, le décodeur MSTDEC reçoit en entrée les bits de référence R0, R1, R2 et les bits K1, K0 formant le nombre K. Le tableau 3 ci-après décrit la fonction logique de production du signal MASTER exécutée par le décodeur MSTDEC. Il apparaît que pour chaque valeur de K, le signal MASTER est à 1 lorsque l'adresse de poids fort R2 R1 R0 correspond à la plus forte valeur possible dans le plan mémoire étendu. Quand K=0, le signal MASTER est toujours à 1 puisque la mémoire fonctionne dans le mode "classique".

Selon l'invention, l'unité centrale UC est configurée pour n'exécuter une commande de lecture de l'un des registres spéciaux STREG, IDREG qu'à la condition que le signal MASTER soit à 1. Le registre est alors transféré sur la sortie IOP de la mémoire via le bus de données interne 5 et le circuit IOCT. Ainsi, vu de l'extérieur, le plan mémoire étendu présente un caractère unitaire en ce qui concerne la lecture des registres spéciaux puisque c'est toujours la mémoire maître qui répond aux commandes de lecture. En d'autres termes, tout se passe comme si le plan mémoire étendu ne comportait qu'un seul exemplaire de chacun des registres spéciaux, ceux des mémoires esclaves n'étant jamais lus et demeurant non accessibles depuis l'extérieur. Tableau 3

| K_{(décimal)} | CNFREG (K1 K0) | IDXREG (R2 R1 R0) | MASTER |
|---|---|---|---|
| 0 | 00 | 000 | 1 |
| 1 | 01 | 001 | 1 |
| 1 | 01 | 000 | 0 |
| 2 | 10 | 011 | 1 |
| 2 | 10 | de 000 à 010 | 0 |
| 3 | 11 | 111 | 1 |
| 3 | 11 | de 000à 110 | 0 |

Les registres spéciaux des mémoires esclaves, bien qu'ils ne soient pas accessibles en lecture, doivent toutefois pouvoir être programmés car ils peuvent agir sur le fonctionnement de ces mémoires. Ainsi, selon l'invention, les bits de protection en écriture P0 à Pi sont affectés à la protection en écriture de fractions du plan mémoire étendu plutôt qu'à la protection de fractions du plan mémoire intégré de la mémoire dans laquelle ils sont enregistrés. Ces bits concernent donc chacune des mémoires, notamment celles qui font partie, le cas échéant, de la fraction du plan mémoire étendu à protéger en écriture. Egalement, le bit WEN est utilisé comme un bit collectif affecté à la protection générale en écriture du plan mémoire étendu, et non à la protection en écriture d'une mémoire déterminée.

Ainsi, et à l'inverse des commandes de lecture, des commandes d'écriture des registres spéciaux sont exécutées par toutes les mémoires, maîtres ou esclaves. Les registres spéciaux contiennent ainsi strictement la même valeur dans chacune des mémoires du plan mémoire étendu et forment chacun l'équivalent d'un registre collectif unique.

Une variante de cet aspect de l'invention consiste à conférer le statut de mémoire maître à la mémoire ayant la plus faible adresse de poids fort, soit tous les bits de référence à 0. Dans ce cas, il n'est pas nécessaire que la mémoire compare ses bits de référence aux bits K0, K1 du nombre K pour savoir si elle est mémoire maître ou non.

### Lecture continue du plan mémoire étendu

L'exécution d'une commande de lecture continue sera maintenant décrite plus en détail. Une telle commande comporte une adresse étendue EAD0 de commencement de lecture, soit une adresse de N+K bits :
[CODE(lecture_continue), EAD₀]

Lorsqu'une telle commande de lecture continue est reçue, les unités centrales respectives des mémoires incrémentent ou décrémentent continuellement et simultanément leurs compteurs d'adresse étendue, et chacune fournit les données demandées lorsque les bits de poids fort du compteur d'adresse étendue deviennent égaux aux bits de référence présents dans le registre d'indexation. Comme les compteurs d'adresse étendue respectifs des diverses mémoires comportent à chaque instant la même valeur d'adresse étendue, les mémoires se relayent automatiquement pour fournir sur le bus série le contenu de leurs plans mémoire intégrés respectifs, ce qui correspond, vu de l'extérieur, à une mémoire unique comportant un plan mémoire intégré de grande taille qui effectuerait une opération de lecture continue de son plan mémoire.

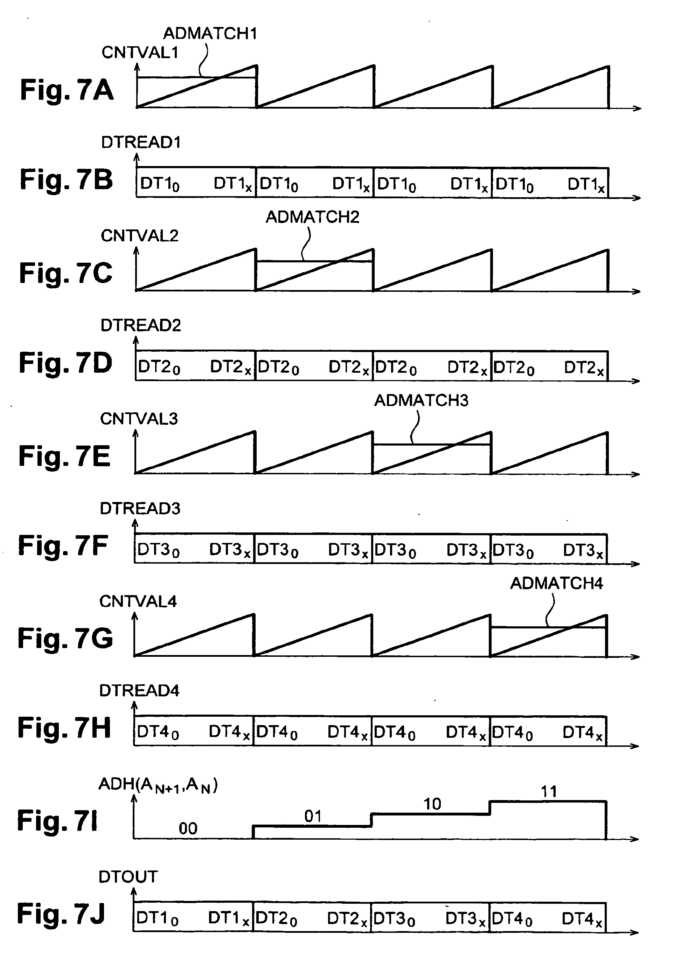

Pour fixer les idées, les figures 7A à 7J illustrent l'exécution d'une commande de lecture continue du plan mémoire étendu représenté en figure 3, formé par les mémoires MEM1 à MEM4. Les figures 7A, 7C, 7E, 7G, représentent des valeurs de comptage CNTVAL1, CNTVAL2, CNTVAL3, CNTVAL4 formées par les N premiers bits du compteur d'adresse étendue des mémoires MEM1, MEM2, MEM3, MEM4, respectivement, soit les adresse ADL. Les figures 7A, 7C, 7E, 7G, représentent également les valeurs des signaux ADMATCH1, ADMATCH2, ADMATCH3, ADMATCH4 à la sortie des comparateurs respectifs des mémoires MEM1, MEM2, MEM3, MEM4. Les figures 7B, 7D, 7F, 7H représentent les données DTREAD1, DTREAD2, DTREAD3, DTREAD4 lues dans les plans mémoire intégrés des mémoire MEM1, MEM2, MEM3, MEM4, respectivement. La figure 7I représente la valeur de comptage de poids fort formée par les deux bits de poids fort A_{N+1}, A_{N} (car ici K=2) présents dans le compteur d'adresse étendue de chaque mémoire, soit l'adresse ADH. La figure 7J représente les données DTOUT qui sont fournies par le plan mémoire intégré. On suppose ici que la lecture continue commence à l'adresse zéro du plan mémoire étendu, et que la mémoire MEM1 est celle qui présente l'adresse de poids fort la plus faible, soit A_{N+1} A_{N}, = 00.

Au cours de la lecture continue, les valeurs de comptage de poids faible CNTVAL1, CNTVAL2, CNTVAL3, CNTVAL4 effectuent plusieurs cycles de comptage en repassant chaque fois par zéro (fig. 7A, 7C, 7E, 7G) tandis que la valeur de comptage de poids fort augmente d'une unité à chaque cycle. A chaque cycle, les unités centrales des mémoires lisent l'ensemble de leurs plans mémoire respectifs, mais ces données ne sont fournies en sortie que lorsque le signal ADMATCH est à 1. Ainsi, les données fournies au cours du premier cycle de comptage sont celles qui sont lues par la mémoire MEM1, et s'étendent du premier mot binaire DT10 jusqu'au dernier mot binaire DT1x présent dans la mémoire MEM1. Les données fournies au cours du second cycle de comptage sont celles qui sont lues par la mémoire MEM2 et s'étendent du premier mot binaire DT20 jusqu'au dernier mot binaire DT2x présent dans la mémoire MEM2. De même, les données fournies au cours du troisième cycle de comptage sont celles qui sont lues par la mémoire MEM3 et s'étendent du premier mot binaire DT30 jusqu'au dernier mot binaire DT3x présent dans la mémoire MEM3. Au cours du quatrième et dernier cycle de comptage, les données fournies sont celles qui sont lues par la mémoire MEM4, et s'étendent du premier mot binaire DT40 jusqu'au dernier mot binaire DT4x présent dans la mémoire MEM4. L'arrêt du processus de lecture peut toutefois intervenir à tout instant, et est généralement déclenché en cessant d'appliquer le signal d'horloge CK0 aux mémoires.

Ainsi, la non-exécution d'une commande de lecture continue en effectuant une lecture du plan mémoire intégré tout en bloquant les données à la sortie de la mémoire, présente un avantage déterminant relativement à une méthode qui consisterait à ne pas effectuer la lecture du plan mémoire. Cette autre méthode nécessiterait la prévision d'un décodeur complexe portant sur tous les bits d'adresse du compteur pour anticiper l'instant où des données vont devoir être fournies, afin d'initialiser la lecture du plan mémoire en temps utile pendant l'exécution d'une commande de lecture continue au cours de laquelle le compteur d'adresse étendue est sans cesse incrémenté ou décrémenté.

Il apparaîtra clairement à l'homme de l'art qu'une mémoire selon l'invention est susceptible de diverses variantes et modes de réalisation. Diverses combinaisons des moyens de l'invention peuvent être prévues, certains moyens pouvant ne pas être mis en oeuvre. Notamment, la mise en oeuvre du contact de disponibilité/occupation RBP et du signal EWIP ne se justifie que si le plan mémoire intégré de chaque mémoire est accessible à la fois en lecture et en écriture (par exemple un plan mémoire de type Flash ou EEPROM). Egalement, la prévision du compteur d'adresse configurable et/ou du comparateur configurable ne se justifie que si l'on souhaite prévoir une mémoire configurable, destinée à être incorporée dans un plan mémoire étendu dont la taille n'est pas prédéterminée. De même, la prévision du signal de mémoire maître ne se justifie que si l'on souhaite prévoir un plan mémoire étendu capable de répondre à une commande de lecture de registres spéciaux. Enfin, bien que l'on ait décrit dans un souci de simplicité la réalisation d'un plan mémoire étendu comportant des mémoires ayant des plans mémoire intégrés de même taille, l'invention s'applique également à la réalisation d'un plan mémoire étendu composite. Dans ce cas, N et K sont différents dans chaque mémoire mais la somme de N et de K est constante et égale au nombre de bits que comprend l'adresse étendue du plan mémoire étendu composite.

## Revendications

1. Mémoire (MEM) sur microplaquette de silicium, comprenant :
- une entrée/sortie série,
- des moyens (IDXREG) pour mémoriser une adresse de poids fort (RADH) attribuée à la mémoire au sein d'un plan mémoire étendu adressable au moyen d'une adresse étendue (EAD) comprenant une adresse de poids faible (ADL) et une adresse de poids fort (ADH),
- un plan mémoire intégré (MA) adressable avec l'adresse de poids faible (ADL), et
au moins un registre (STREG, IDREG) accessible en lecture,
**caractérisée en ce qu'**elle comprend :
- des moyens (MSTDEC) pour fournir un signal de mémoire maître (MASTER) présentant une valeur active ou une valeur inactive, à partir de l'adresse de poids fort (RADH) attribuée à la mémoire, le signal de mémoire maître à la valeur active signifiant que la mémoire est maître au sein du plan mémoire étendu, le signal de mémoire maître à la valeur inactive signifiant que la mémoire est esclave au sein du plan mémoire étendu, et
- une unité centrale (UC) pour exécuter une commande de lecture du registre (STREG, IDREG) et de fourniture du contenu du registre sur l'entrée/sortie série de la mémoire, uniquement si la mémoire est mémoire maître au sein du plan mémoire étendu.

2. Mémoire selon la revendication 1, comprenant :
- des moyens (CNFREG) pour mémoriser une information (K1, K0) sur la taille du plan mémoire étendu, et
- des moyens (MSTDEC) pour fournir le signal de mémoire maître à partir de l'adresse de poids fort (RADH) attribuée à la mémoire et de l'information (K1, K0) sur la taille du plan mémoire étendu.

3. Mémoire selon la revendication 2, dans laquelle l'information (K1, K0) sur la taille du plan mémoire étendu comprend le nombre (K) de bits que comprend l'adresse de poids fort (ADH) présente dans une adresse étendue (EAD).

4. Mémoire selon l'une des revendications 2 et 3, dans laquelle le signal de mémoire maître est porté à la valeur active si l'adresse de poids fort (RADH) attribuée à la mémoire est la plus forte adresse de poids fort (RADH) attribuée au sein du plan mémoire étendu.

5. Mémoire selon l'une des revendications 1 à 4, dans laquelle le registre est un registre d'état (STREG) comprenant des bits de protection en écriture du plan mémoire étendu.

6. Mémoire selon l'une des revendications 1 à 5, dans laquelle le registre est un registre d'identification (IDREG) comprenant une donnée d'identification de la mémoire.

7. Mémoire selon l'une des revendications 1 à 6, dans laquelle l'unité centrale est configurée pour exécuter une commande d'écriture du registre (STREG, IDREG) quelle que soit la valeur du signal de mémoire maître

8. Mémoire selon l'une des revendications 2 à 4, dans laquelle les moyens pour fournir un signal de mémoire maître comprennent un circuit de décodage (MSTDEC) recevant en entrée l'information (K1, K0) sur la taille du plan mémoire étendu et l'adresse de poids fort (RADH) attribuée à la mémoire.

9. Mémoire selon l'une des revendications 1 à 8, comprenant :
- un compteur d'adresse étendue (EACNT) pour mémoriser une adresse étendue (EAD) reçue sur l'entrée/sortie série de la mémoire,
- des moyens (COMP) pour comparer l'adresse de poids fort (ADH) de l'adresse étendue avec l'adresse de poids fort (RADH) attribuée à la mémoire, et
- des moyens (COMP, ADMATCH, SHZ, OUTBUF) pour empêcher l'exécution d'une commande de lecture ou d'écriture du plan mémoire intégré (MA) si l'adresse de poids fort (ADH) de l'adresse étendue est différente de l'adresse de poids fort (RADH) attribuée à la mémoire.

10. Mémoire selon la revendication 9, comprenant
- un circuit tampon de sortie (OUTBUF) pour fournir sur l'entrée/sortie série de la mémoire des données lues dans le plan mémoire intégré (MA), et
- un comparateur (COMP) pour fournir un signal de blocage (ADMATCH, SHZ) du circuit tampon de sortie (OUTBUF) si l'adresse de poids fort (ADH) de l'adresse étendue est différente de l'adresse de poids fort (RADH) attribuée à la mémoire.

11. Mémoire selon l'une des revendications 1 à 11, comprenant des contacts spécifiques (IDXP0-IDXP2) permettant de configurer l'adresse de poids fort (RADH) attribuée à la mémoire, en appliquant des potentiels électriques déterminés sur chacun des contacts spécifiques.

12. Procédé pour la réalisation d'un plan mémoire étendu adressable au moyen d'une adresse étendue (EAD) comprenant une adresse de poids faible (ADL) et une adresse de poids fort (ADH), le plan mémoire étendu comprenant une pluralité de mémoires série intégrées sur microplaquettes de silicium, chaque mémoire comprenant une entrée/sortie série, un plan mémoire intégré (MA) adressable avec l'adresse de poids faible (ADL), et au moins un registre (STREG, IDREG) accessible en lecture après application à la mémoire d'une commande de lecture du registre, les entrées/sorties série des mémoires étant interconnectées, procédé comprenant les étapes consistant à :
- attribuer à chaque mémoire une adresse de poids fort (RADH) au sein du plan mémoire étendu,
- désigner, dans le plan mémoire étendu, une seule mémoire maître et des mémoires esclaves, et
- configurer les mémoires de manière que seule la mémoire maître exécute une commande de lecture du registre (STREG, IDREG), et que les mémoires esclaves n'exécutent pas une telle commande.

13. Procédé selon la revendication 12, comprenant les étapes consistant à prévoir, dans chaque mémoire :
- des moyens (IDXREG) pour mémoriser l'adresse de poids fort (RADH) attribuée à la mémoire,
- des moyens (MSTDEC) pour fournir un signal de mémoire maître présentant une valeur active ou une valeur inactive, à partir de l'adresse de poids fort (RADH) attribuée à la mémoire, le signal de mémoire maître à la valeur active signifiant que la mémoire est maître au sein du plan mémoire étendu, le signal de mémoire maître à la valeur inactive signifiant que la mémoire est esclave au sein du plan mémoire étendu, et
- une unité centrale (UC) pour exécuter une commande de lecture du registre (STREG, IDREG) et de fourniture du contenu du registre sur l'entrée/sortie série de la mémoire, uniquement si la mémoire est mémoire maître au sein du plan mémoire étendu.

14. Procédé selon la revendication 13, comprenant les étapes consistant à prévoir, dans chaque mémoire :
- des moyens (CNFREG) pour mémoriser une information (K1, K0) sur la taille du plan mémoire étendu, et
- des moyens (MSTDEC) pour fournir le signal de mémoire maître à partir de l'adresse de poids fort (RADH) attribuée à la mémoire et de l'information (K1, K0) sur la taille du plan mémoire étendu.

15. Procédé selon la revendication 14, dans lequel l'information (K1, K0) sur la taille du plan mémoire étendu comprend le nombre de bits de poids fort présents dans une adresse étendue (EAD) appliquée au plan mémoire.

16. Procédé selon l'une des revendications 14 et 15, dans lequel chaque mémoire fournit le signal de mémoire maître au moyen d'un circuit (MSTDEC) de décodage de l'information (K1, K0) sur la taille du plan mémoire étendu et de l'adresse de poids fort (RADH) attribuée à la mémoire.

17. Procédé selon l'une des revendications 12 à 16, dans lequel une mémoire est mémoire maître si elle se voit attribuer la plus forte adresse de poids fort (RADH) au sein du plan mémoire étendu.

18. Procédé selon l'une des revendications 12 à 17, dans lequel le registre est un registre d'état (STREG) comprenant des bits de protection en écriture du plan mémoire étendu.

19. Procédé selon l'une des revendications 12 à 18, dans lequel le registre est un registre d'identification (IDREG) comprenant une donnée d'identification de la mémoire.

20. Procédé selon l'une des revendications 12 à 19, dans lequel une commande d'écriture du registre (STREG, IDREG) est exécutée par toutes les mémoires.

## Claims

1. A memory (MEM) on a silicon microchip, comprising
- a serial input/output
- means (IDXREG) for storing a most significant address (RADH) allocated to the memory within an extended memory array addressable by means of an extended address (EAD) comprising a least significant address (ADL) and a most significant address (ADH),
- an integrated memory array (MA) addressable with the least significant address (ADL), and at least one read accessible register (STREG, IDREG),
**characterized in that** it comprises:
- means (MSTDEC) for supplying a master memory signal (MASTER) having an active value or an inactive value, based on the most significant address (RADH) allocated to the memory, the master memory signal with the active value meaning that the memory is master within the extended memory array, the master memory signal with the inactive value meaning that the memory is slave within the extended memory array, and
- a central processing unit (UC) for executing a command for reading the register (STREG, IDREG) and for supplying the content of the register to the serial input/output of the memory, only if the memory is master memory within the extended memory array.

2. Memory according to claim 1, comprising:
- means (CNFREG) for storing a piece of information (K1, K0) about the size of the extended memory array, and
- means (MSTDEC) for supplying the master memory signal based on the most significant address (RADH) allocated to the memory and the piece of information (K1, K0) about the size of the extended memory array.

3. Memory according to claim 2, wherein the piece of information (K1, K0) about the size of the extended memory array comprises the number (K) of bits that the most significant address (ADH) present in an extended address (EAD) comprises.

4. Memory according to one of claims 2 and 3, wherein the master memory signal is taken to the active value if the most significant address (RADH) allocated to the memory is the most significant one (RADH) allocated within the extended memory array.

5. Memory according to one of claims 1 to 4, wherein the register is a status register (STREG) comprising bits for write protecting the extended memory array.

6. Memory according to one of claims 1 to 5, wherein the register is an identification register (IDREG) comprising an identification datum of the memory.

7. Memory according to one of claims 1 to 6, wherein the central processing unit is configured for executing a command for writing the register (STREG, IDREG) whatever the value of the master memory signal.

8. Memory according to one of claims 2 to 4, wherein the means for supplying a master memory signal comprise a decoding circuit (MSTDEC) receiving at input the piece of information (K1, K0) about the size of the extended memory array and the most significant address (RADH) allocated to the memory.

9. Memory according to one of claims 1 to 8, comprising:
- an extended address counter (EACNT) for storing an extended address (EAD) received at the serial input/output of the memory,
- means (COMP) for comparing the most significant address (ADH) of the extended address with the most significant address (RADH) allocated to the memory, and
- means (COMP, ADMATCH, SHZ, OUTBUF) for preventing the execution of a command for reading or writing the integrated memory array (MA) if the most significant address (ADH) of the extended address is different to the most significant address (RADH) allocated to the memory.

10. Memory according to claim 9, comprising
- an output buffer circuit (OUTBUF) for supplying to the serial input/output of the memory data read in the integrated memory array (MA), and
- a comparator (COMP) for supplying a signal for blocking (ADMATCH, SHZ) the output buffer circuit (OUTBUF) if the most significant address (ADH) of the extended address is different to the most significant address (RADH) allocated to the memory.

11. Memory according to one of claims 1 to 11, comprising specific pads (IDXPO-IDXP2) enabling the most significant address (RADH) allocated to the memory to be configured, by applying determined electric potentials to each of the specific pads.

12. Method for producing an extended memory array addressable by means of an extended address (EAD) comprising a least significant address (ADL) and a most significant address (ADH), the extended memory array comprising a plurality of serial memories integrated onto silicon microchips, each memory comprising a serial input/output, an integrated memory array (MA) addressable with the least significant address (ADL) and at least one register (STREG, IDREG) that is read accessible after applying a command for reading the register to the memory, the serial inputs/outputs of the memories being interconnected, a method comprising the steps of:
- allocating to each memory a most significant address (RADH) within the extended memory array,
- designating, in the extended memory array, only one master memory and slave memories, and
- configuring the memories so that only the master memory executes a command for reading the register (STREG, IDREG), and the slave memories do not execute such a command.

13. Method according to claim 12, comprising the steps of providing, in each memory:
- means (IDXREG) for storing the most significant address (RADH) allocated to the memory,
- means (MSTDEC) for supplying a master memory signal having an active value or an inactive value, based on the most significant address (RADH) allocated to the memory, the master memory signal with the active value meaning that the memory is master within the extended memory array, the master memory signal with the inactive value meaning that the memory is slave within the extended memory array, and
- a central processing unit (UC) for executing a command for reading the register (STREG, IDREG) and for supplying the content of the register to the serial input/output of the memory, only if the memory is master memory within the extended memory array.

14. Method according to claim 13, comprising the steps of providing, in each memory:
- means (CNFREG) for storing a piece of information (K1, K0) about the size of the extended memory array, and
- means (MSTDEC) for supplying the master memory signal based on the most significant address (RADH) allocated to the memory and the piece of information (K1, K0) about the size of the extended memory array.

15. Method according to claim 14, wherein the piece of information (K1, K0) about the size of the extended memory array comprises the number of most significant bits present in an extended address (EAD) applied to the memory array.

16. Method according to one of claims 14 and 15, wherein each memory supplies the master memory signal by means of a circuit (MSTDEC) for decoding the piece of information (K1, K0) about the size of the extended memory array and of the most significant address (RADH) allocated to the memory.

17. Method according to one of claims 12 to 16, wherein a memory is master memory if it is allocated the most significant of the most significant addresses (RADH) within the extended memory array.

18. Method according to one of claims 12 to 17, wherein the register is a status register (STREG) comprising bits for write protecting the extended memory array.

19. Method according to one of claims 12 to 18, wherein the register is an identification register (IDREG) comprising an identification datum of the memory.

20. Method according to one of claims 12 to 19, wherein a command for writing the register (STREG, IDREG) is executed by all the memories.

## Patentansprüche

1. Speicher (MEM) auf Siliziumchip, umfassend:
- einen seriellen Ein-/Ausgang,
- Mittel (IDXREG) zur Speicherung einer höherwertigen Adresse (RADH), die dem Speicher innerhalb einer erweiterten Speicherebene zugewiesen ist, die mit einer erweiterten Adresse (EAD) adressiert werden kann, die aus einer niederwertigen Adresse (ADL) und einer höherwertigen Adresse (ADH) besteht,
- eine integrierte Speicherebene (MA), die durch die niederwertige Adresse (ADL) adressierbar ist, und mindestens ein für Lesezugriff zugängliches Register (STREG, IDREG),
**dadurch gekennzeichnet, dass** er umfasst:
- Mittel (MSTDEC) zur Erzeugung eines Master-Speicher-Signals (MASTER), das einen aktiven oder einen inaktiven Wert aufweist, aus der höherwertigen Adresse (RADH), die dem Speicher zugeordnet ist, wobei die Tatsache, dass das Master-Speicher-Signal den aktiven Wert hat, bedeutet, dass der Speicher innerhalb der erweiterten Speicherebene Master ist, während die Tatsache, dass das Master-Speicher-Signal den inaktiven Wert hat, bedeutet, dass der Speicher in der erweiterten Speicherebene Slave ist, und
- eine Zentraleinheit (UC) zur Ausführung eines Befehls zum Lesen des Registers (STREG, IDREG) und Anlegen des Inhalts des Registers an den seriellen Ein-/Ausgang des Speichers ausschließlich, wenn der Speicher Master-Speicher in der erweiterten Speicherebene ist.

2. Speicher nach Patentanspruch 1, umfassend:
- Mittel (CNFREG) zur Speicherung einer Information (K1, K0) über die Größe der erweiterten Speicherebene, und
- Mittel (MSTDEC) zur Ausgabe des Master-Speicher-Signals aufgrund der höherwertigen Adresse (RADH), die dem Speicher zugeordnet ist, und der Information (K1, K0) über die Größe der erweiterten Speicherebene.

3. Speicher nach Patentanspruch 2, in dem die Information (K1, K0) über die Größe der erweiterten Speicherebene die Anzahl (K) an Bits umfasst, die die in einer erweiterten Adresse (EAD) enthaltene höherwertige Adresse (ADH) umfasst.

4. Speicher nach einem der Patentansprüche 2 und 3, in dem das Master-Speicher-Signal auf den aktiven Wert gesetzt wird, wenn die dem Speicher zugewiesene höherwertige Adresse (RADH) die höchstwertige der höherwertigen Adressen (RADH) ist, die innerhalb der erweiterten Speicherebene zugewiesen ist.

5. Speicher nach einem der Patentansprüche 1 bis 4, in dem das Register ein Zustandsregister (STREG) ist, das Bits zum Schreibschutz der erweiterten Speicherebene umfasst.

6. Speicher nach einem der Patentansprüche 1 bis 5, in dem das Register ein Identifizierungsregister (IDREG) ist, das eine Information zur Identifizierung des Speichers enthält.

7. Speicher nach einem der Patentansprüche 1 bis 6, in dem die Zentraleinheit derart eingerichtet ist, dass sie unabhängig vom Wert des Master-Speicher-Signals einen Befehl zum Schreiben in das Register (STREG, IDREG) ausführt.

8. Speicher nach einem der Patentansprüche 2 bis 4, in dem die Mittel zur Erzeugung eines Master-Speicher-Signals eine Decoder-Schaltung (MSTDEC) umfassen, die am Eingang die Information (K1, K0) über die Größe der erweiterten Speicherebene und die höherwertige Adresse (RADH), die dem Speicher zugewiesen ist, empfängt.

9. Speicher nach einem der Patentansprüche 1 bis 8, umfassend:
- einen Zähler der erweiterten Adresse (EACNT) zur Speicherung einer erweiterten Adresse (EAD), die am seriellen Ein-/Ausgang des Speichers empfangen wurde,
- Mittel (COMP) zum Vergleich der höherwertigen Adresse (ADH) der erweiterten Adresse mit der dem Speicher zugewiesenen höherwertigen Adresse (RADH), und
- Mittel (COMP, ADMATCH, SHZ, OUTBUF) zur Verhinderung der Ausführung eines Lese- oder Schreibbefehls der integrierten Speicherebene (MA), wenn die höherwertige Adresse (ADH) der erweiterten Adresse sich von der dem Speicher zugewiesenen höherwertigen Adresse (RADH) unterscheidet.

10. Speicher nach Patentanspruch 9, umfassend
- eine Ausgangspufferschaltung (OUTBUF) zum Anlegen von in der integrierten Speicherebene (MA) gelesenen Daten an den seriellen Ein-/Ausgang des Speichers, und
- einen Vergleicher (COMP) zur Ausgabe eines Signals (ADMATCH, SHZ) zur Sperrung der Ausgangspufferschaltung (OUTBUF), wenn sich die höherwertige Adresse (ADH) der erweiterten Adresse von der höherwertigen Adresse (RADH) unterscheidet, die dem Speicher zugeordnet ist.

11. Speicher nach einem der Patentansprüche 1 bis 11, besondere Anschlüsse (IDXPO-IDXP2) umfassend, die erlauben, die dem Speicher zugewiesene höherwertige Adresse (RADH) durch Anlegen bestimmter elektrischer Potentiale an jeden der besonderen Anschlüsse zu konfigurieren.

12. Verfahren zur Herstellung einer erweiterten Speicherebene, die mit einer erweiterten Adresse (EAD), eine niederwertige Adresse (ADL) und eine höherwertige Adresse (ADH) umfassend, adressiert werden kann, wobei die erweiterte Speicherebene mehrere Seriellspeicher umfasst, die auf einem Silizium-Chip integriert sind, wobei jeder Speicher einen seriellen Ein-/Ausgang umfasst, eine integrierte Speicherebene (MA), die mit der niederwertigen Adresse (ADL) adressiert werden kann, und mindestens ein Register STREG, IDREG), das nach Anlegen eines Befehls zum Lesen des Registers für Lesezugriff zugänglich ist, wobei die seriellen Ein/Ausgänge der Speicher miteinander verbunden sind, Verfahren, die folgenden Schritte umfassend:
- Zuweisung einer höherwertigen Adresse (RADH) zu jedem Speicher der erweiterten Speicherebene,
- Ausweisung in der erweiterten Speicherebene eines einzigen Master-Speichers und von Slave-Speichern, und
- Konfigurierung der Speicher derart, dass nur der Master-Speicher einen Befehl zum Lesen des Registers (STREG, IDREG) ausführt und die Slave-Speicher einen derartigen Befehl nicht ausführen.

13. Verfahren nach Patentanspruch 12, die folgenden Schritte umfassend, die darin bestehen, in jedem Speicher bereitzustellen:
- Mittel (IDXREG) zur Speicherung einer höherwertigen Adresse (RADH), die dem Speicher zugewiesen ist,
- Mittel (MSTDEC) zur Erzeugung eines Master-Speicher-Signals, das einen aktiven oder einen inaktiven Wert aufweist, aus der höherwertigen Adresse (RADH), die dem Speicher zugeordnet ist, wobei die Tatsache, dass das Master-Speicher-Signal den aktiven Wert hat, bedeutet, dass der Speicher in der erweiterten Speicherebene Master ist, während die Tatsache, dass das Master-Speicher-Signal den inaktiven Wert hat, bedeutet, dass der Speicher in der erweiterten Speicherebene Slave ist, und
- eine Zentraleinheit (UC) zur Ausführung eines Befehls zum Lesen des Registers (STREG, IDREG) und Anlegen des Inhalts des Registers an den seriellen Ein-/Ausgang des Speichers ausschließlich, wenn der Speicher innerhalb der erweiterten Speicherebene Master-Speicher ist.

14. Verfahren nach Patentanspruch 13, die folgenden Schritte umfassend, die darin bestehen, in jedem Speicher bereitzustellen:
- Mittel (CNFREG) zur Speicherung einer Information (K1, K0) über die Größe der erweiterten Speicherebene, und
- Mittel (MSTDEC) zur Ausgabe des Master-Speicher-Signals aufgrund der höherwertigen Adresse (RADH), die dem Speicher zugeordnet ist, und der Information (K1, K0) über die Größe der erweiterten Speicherebene.

15. Verfahren nach Patentanspruch 14, in dem die Information (K1, K0) über die Größe der erweiterten Speicherebene die Anzahl an höherwertigen Bits umfasst, die in einer erweiterten Adresse (EAD) enthalten ist, die an die Speicherebene angelegt wird.

16. Verfahren nach einem der Patentansprüche 14 und 15, in dem jeder Speicher das Master-Speicher-Signal mit Hilfe einer Schaltung (MSTDEC) zur Decodierung der Information (K1, K0) über die Größe der erweiterten Speicherebene und der höherwertigen Adresse (RADH), die dem Speicher zugewiesen ist, liefert.

17. Verfahren nach einem der Patentansprüche 12 bis 16, in dem ein Speicher Master-Speicher ist, wenn ihm die höchstwertige der höherwertigen Adressen (RADH) innerhalb der erweiterten Speicherebene zugewiesen ist.

18. Verfahren nach einem der Patentansprüche 12 bis 17, in dem das Register ein Zustandsregister (STREG) ist, das Bits zum Schreibschutz der erweiterten Speicherebene umfasst.

19. Verfahren nach einem der Patentansprüche 12 bis 18, in dem das Register ein Identifizierungsregister (IDREG) ist, das eine Information zur Identifizierung des Speichers enthält.

20. Verfahren nach einem der Patentansprüche 12 bis 19, in dem von allen Speichern ein Befehl zum Schreiben in das Register (STREG, IDREG) ausgeführt wird.
